# DEMANDE DE BREVET EUROPEEN

(11) **EP 0 626 226 A1**
(43) Date de publication de la demande: **30.11.1994**
(21) Numéro de dépôt: 93401327.7
(22) Date de dépôt: 24.05.1993
(51) Int. Cl.: B23K 1/08, B23K 3/06

(54) **Machine à souder en continu les connexions de circuits électroniques**

(71) Demandeur: Coeffe, Claude, F-92250 La Garenne-Colombes (FR)
(72) Inventeur: Coeffe, Claude, F-92250 La Garenne-Colombes (FR)
(74) Mandataire: Pinguet, André

(57) **Abrégé**

Machine permettant de souder en continu des connexions sur des plaquettes portant des circuits électroniques, notamment des circuits hybrides montés sur des plaquettes de céramique. La machine constitue un banc doté d'un convoyeur (10) à hauteur ajustable manuellement au moyen de chandelles (12), d'un poste de fluxage (13) doté d'un jet d'air, d'un poste de préchauffage (14) portant les plaquettes à une température de l'ordre de 160°, et d'un poste de soudage (15) doté d'une buse dans laquelle les plaquettes défilent à vitesse constante en position verticale.

## Description

La présente invention concerne une machine permettant de souder en continu des connexions très rapprochés regulièrement réparties sur les deux bords latéraux de plaquettes portant des circuits électroniques.

La présente invention concerne plus particulièrement des plaquettes de céramique portant des circuits hybrides recouverts au moins en partie par une couche de céramique ou de toute autre matière isolante. Ces plaquettes sont dotées sur leurs bords latéraux de plages conductrices régulièrement espacées. On donne à l'avance à l'extrémité supérieure de chaque connexion une forme de pince qui est fixée mécaniquement à l'une des plages conductrices de la plaquette, alors que les extrémités inférieures de ces connexions sont encore liées au bord de la bande métallique dans laquelle celles-ci ont été découpées au pas de 2,54 mm ou à un pas plus court.

Il en résulte que lorsque les connexions sont fixées mécaniquement à leurs plaquettes respectives, ces plaquettes sont liées entre elles par la base des connexions pour former un train continu de plaquettes. Une telle liaison entre les plaquettes va faciliter la mise en place des plaquettes sur la machine à souder en continu conforme à l'invention.

Une telle disposition des plaquettes sur la machine permettra de faire défiler à la même vitesse les parties à souder devant les divers postes de la machine. Plus particulièrement, elle permettra d'éviter d'enfoncer verticalement la plaquette dans le bain de soudure. En effet, on a constaté qu'une soudure parfaitement fiable ne peut être obtenue qu'en évitant de recourir à un tel processus : lorsque l'on remontre la plaquette du bain de soudure, il arrive qu'une petite gouttelette de soudure se fixe par capillarité sur la connexion et qu'elle rende l'isolement aléatoire.

En définitive, la machine à souder en continu selon l'invention est constituée par un banc parcouru longitudinalement par un convoyeur, muni d'un poste de chargement de plaquettes portant déjà les connexions à souder, fixées mécaniquement à leurs sommets aux plages conductrices des plaquettes et reliées entre elles à leur base, un poste de fluxage, un poste de préchauffage et un poste de soudure terminé par un poste de soufflage, caractérisée en ce que les plaquettes munies des connexions à souder sont maintenues durant tout leur trajet dans une position rigoureusement verticale par le convoyeur et passent dans le poste de soudure au-dessus de la paroi longitudinale arrière de la buse.

Avantageusement, lesdites plaquettes défilent au poste de soudage, à vitesse constante, et la ligne des soudures est maintenue à niveau horizontal rigoureusement constant lorsque les plaquettes défilent au-dessus de la paroi longitudinale arrière de la buse.

Dans une forme de réalisation avantageuse, le niveau du métal fondu dans la buse déterminé par l'action de la turbine dotée de son variateur électronique est parfaitement stabilisé par la mise en place à la base de la buse, d'une double grille percée d'ouvertures décalées.

Pour maintenir la ligne des soudres tangente à la surface du métal fondu de la buse tout en effleurant légèrement cette surface, on règle, d'une part, la hauteur du convoyeur en agissant manuellement sur les chandelles et, d'autre part, on agit avec précision sur la vitesse de rotation de la turbine.

Avantageusement, la température de préchauffage de la zone de soudure de la plaquette est réglée à la sortie du tunnel à une valeur inférieure de 60°C à la température du métal fondu dans la buse de soudure.

L'invention sera mieux comprise si l'on se reporte à la description qui va suivre, donnée à titre d'exemple nullement limitatif dans laquelle :
- la figure 1 décrit la liaison mécanique établie à l'avance entre les connexions à souder et la plage conductrice de la plaquette,
- la figure 2 montre la formation de trains de plaquettes,
- la figure 3 représente une vue d'ensemble de la machine faisant l'objet de l'invention,
- la figure 4 fait ressortir la saisie d'un train de plaquettes par le convoyeur,
- la figure 5 représente le poste de fluxage,
- la figure 6 concerne le poste de préchauffage,
- la figure 7 est une vue en perspective du poste de soudure,
- la figure 8 est une coupe verticale de la buse du poste de soudure, et
- la figure 9 représente un poste de coupe programmée du train de plaquettes.

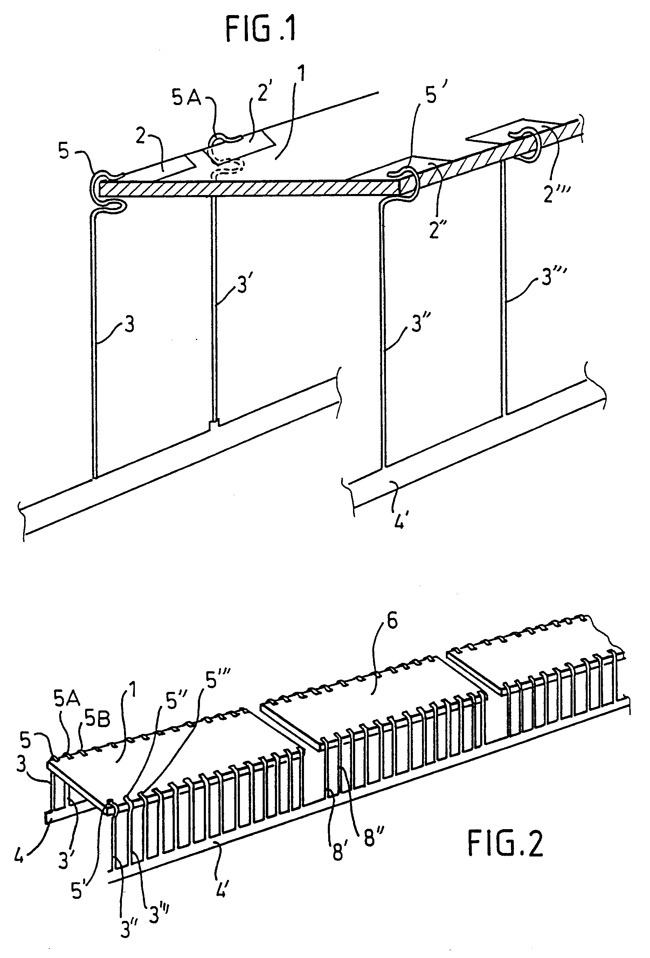

En se reportant à la figure 1, on voit une plaquette (1) portant sur ses bords latéraux des plages conductrices (2), (2'), (2''). Les connexions telles que (3) sont liées encore à la plaque métallique conductrice (4) ou (4') dans laquelle elles ont été découpées. On donne à l'extrémité supérieure de la connexion (3) la forme d'une pince (5) qui est placée en contact mécanique avec la plage conductrice (2) de la plaquette (1). L'objet de l'invention est de rendre parfaitement fiable la soudure que l'on va opérer entre la pince (5) de la connexion (3) et la plage conductrice (2) de la plaquette sans altérer par une action thermique excessive les éléments hybrides incorporés dans la plaquette (1) et sans créer des soudures parasites entre les connexions (3).

La figure 2 fait apparaître la formation des trains de plaquettes. On voit que la plaquette (1), dotée des connexions telles que (3) ou (3'') fixées mécaniquement à la plaquette (1) par l'intermédiaire de pinces telles que (5) ou (5'), est solidarisée avec la plaquette suivante (6) par l'intermédiaire des bandes restantes (4) ou (4') de la plaque métallique dans laquelle les connexions (3''), (3'''), (8'), (8'') ont été découpées.

Ces plaquettes qui portent des connexions sur les deux faces latérales sont souvent désignées sous le nom de "DIL". Sur ces plaquettes, il y a donc deux lignes de connexions, la ligne (5, 5A, 5B) et la ligne de connexions (5', 5'') à souder à la plaquette (1). Les plaquettes ne portant des connexions que sur l'une des faces latérales sont désignées sous le nom de "SIL". Les plaquettes réalisées par les différents constructeurs ne portent pas forcément le même nombre de connexions, ce qui fait que la longueur de la plaquette peut varier dans certaines limites.

En ce qui concerne la largeur des plaquettes, elle est souvent comprise entre 1/2 pouce et 3 pouces (soit entre 1,25 cm et 7,62 cm).

Nous allons décrire ci-dessous la machine destinée plus spécialement au soudage en continu des connexions de DIL. La variante destinée aux connexions de SIL sera examinée plus loin.

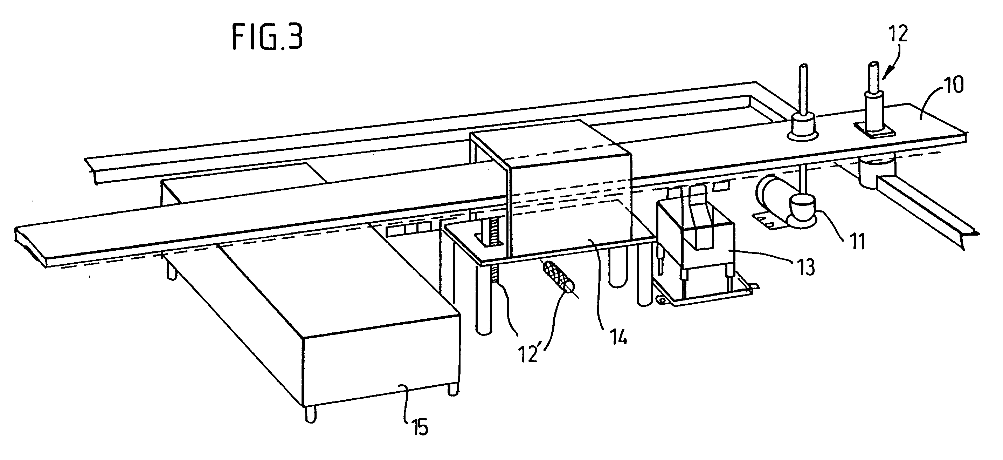

De sorte que la figure 3 présente une vue d'ensemble de la machine à souder automatiquement en continu les connexions des plaquettes du type DIL.

Cette machine comprend un convoyeur (10) qui traverse la machine dans le sens longitudinal entraînant à vitesse constante des pinces equidistantes grâce à un moteur (11) à courant continu doté d'un variateur électronique.

Le convoyeur (10) est supporté par un ensemble de chandelles telles que (12') permettant d'amener par un réglage manuel les pinces à une hauteur appropriée en fonction de la largeur transversale des plaquettes tandis que les chandelles (12) assurent le guidage.

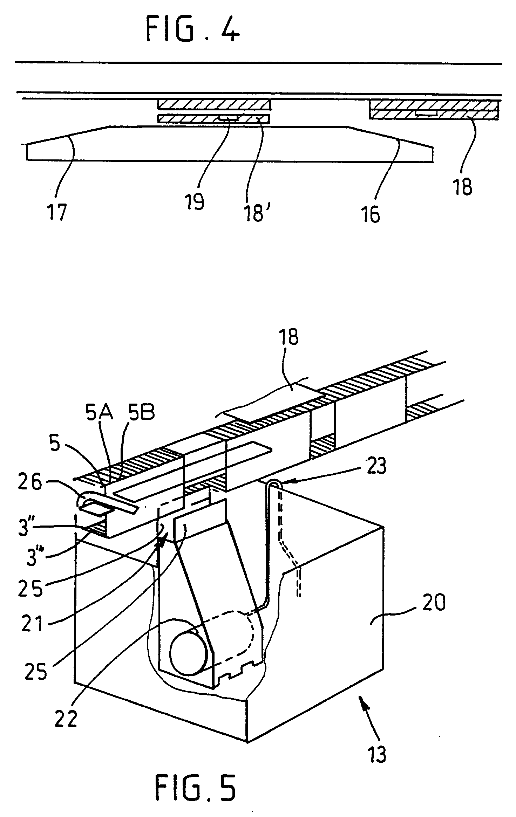

Les pinces saisissent de façon automatique le train de plaquettes qui leur est présenté à l'entrée de la machine et elles ne relâchent ces plaquettes qu'à la sortie de la machine, après l'opération de soudure. Le fonctionnement de ces pinces sera décrit de façon plus précise en référence à la figure 4. Une fois que le train de plaquettes est fixée au convoyeur, il traverse à vitesse constante le poste de fluxage (13). A la sortie de ce dernier, les connexions sont soumises à l'action d'un courant d'air destiné à souffler l'excès de flux. Toujours entraîné par le convoyeur, le train de plaquettes défile dans une chambre de préchauffage (14) dont la température a été réglée de telle sorte que les plaquettes arrivant ensuite au poste de soudage (15) ont acquis la température souhaitée pour réaliser la soudure dans les meilleurs conditions. Le train de plaquettes est alors amené très légèrement au-dessus de la buse de métal fondu du poste de soudure (15). A la sortie du poste de soudage (15), le train de plaquettes peut être soumis à un soufflage d'air chaud s'il s'établit des contacts indésirables pendant la soudure.

Le train de plaquettes sort alors de la machine. Après ouverture automatique des pinces, il s'évacue par gravité.

La figure 4 permet de mieux comprendre la saisie d'un train de plaquettes par les pinces (18) du convoyeur.

Il faut d'abord noter que pour souder les connexions telles que (3'') ou (3''') à la plaquette (1) (figure 2), il faut tremper la ligne de soudure (5', 5'', 5''') dans le métal fondu ; il est donc nécessaire de placer en position horizontale le plan défini par les connexions 3, 3' et par le reliquat (4) de la plaque conductrice dans laquelle on a découpé les connexions, ce qui s'obtient facilement en plaçant ce plan (3, 3', 4) entre les pinces du convoyeur. Les pinces (18), (18') liées au convoyeur sont fixées à des intervalles réguliers sur celui-ci. Chacune de ces pinces est prolongée par un bras fixe lié au convoyeur et par un bras mobile rappelé élastiquement contre le bras fixe. Le bras mobile glisse sur une rampe parallèle au convoyeur. Lorsque le bras mobile atteint la partie ascendante (16) de la rampe, la pince s'ouvre. Cette ouverture autorise l'introduction du plan des connexions (3, 3', 4) de la plaquette (1). La pince (18) ayant saisi la plaquette (1), le bras glissant atteint la rampe descendante (17) qui commande la fermeture de la pince (18). Une butée (19) empêche cependant le bras mobile de basculer vers l'avant et de perturber la fermeture de la pince. Enfin, le convoyeur est conçu pour une dépose rapide permettant des interventions de nettoyage ou d'autres réglages.

La figure 5 représente le poste de fluxage (13). Cet appareil comprend essentiellement une cuve (20) contenant le liquide de fluxage surmontée par une buse (21). Par ailleurs, au fond de la cuve se trouve un tube poreux (22) alimenté en air comprimé par le conduit (23). L'air qui s'échappe par les porosités du tube (22) entraîne des bulles chargées de flux dans la buse (21) et forme une vague mouvante. Le train de plaquettes passe à travers ce flux entre les deux parois latérales telles que (24) et (25). A la sortie du poste de fluxage, une conduite d'air élimine par soufflage l'excès de flux déposé sur les connexions.

Sur la figure 5, on a fait figurer la pince (18) du convoyeur afin de permettre de mieux comprendre la position du train de plaquettes sur le banc au moment de son entrée dans les différents postes de la machine. On voit notamment que toute la zone entourant les points de contact entre les connexions (3''), (3''') et la plaquette (1) est soumise à l'action du flux. On définit ainsi la partie essentielle à traiter. C'est la ligne de soudures (5', 5'' et 5''') aux extrémités des connexions (3''), (3''').

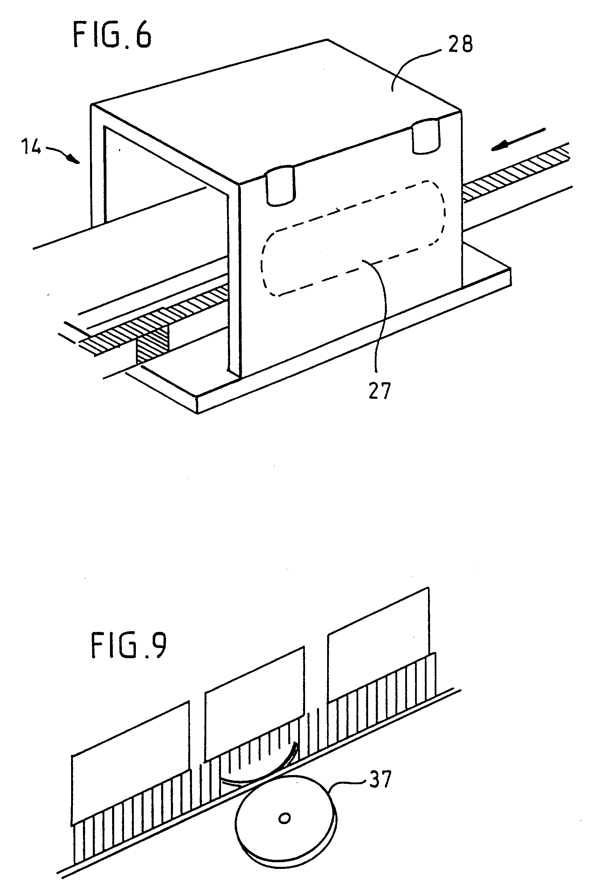

La figure 6 présente le poste de préchauffage. Il est essentiellement constitué par un tunnel (27) formé par un enroulement parcouru par un courant. L'intensité de ce courant est telle que le rayonnement réchauffant la plaquette soit compris uniquement dans le spectre de l'infra-rouge.

Un régulateur détermine l'intensité de courant nécessaire pour que la plaquette sorte du dispositif de préchauffage à une température bien déterminée de l'ordre de 110° à 160°C. Le régulateur est muni d'une alarme interdisant le démarrage du convoyeur tant que la température à la sortie du tunnel n'a pas atteint la valeur prévue inférieure de 60°C à la température du métal fondu.

Le tunnel infra-rouge et la chambre (28) qui le contient peuvent être séparés en deux parties pour permettre la dépose du convoyeur ainsi que le nettoyage et éventuellement le remplacement rapide de la résistance infra-rouge.

Le tunnel est équipé d'un isolant thermique pris en sandwich entre deux tôles en inox. Il va de soi que la position du convoyeur par rapport au tunnel infra-rouge doit tenir compte de la largeur des plaquettes en cours de soudage qui peut aller de 3 pouces à 1/2 pouce ainsi que cela a été indiqué précédemment.

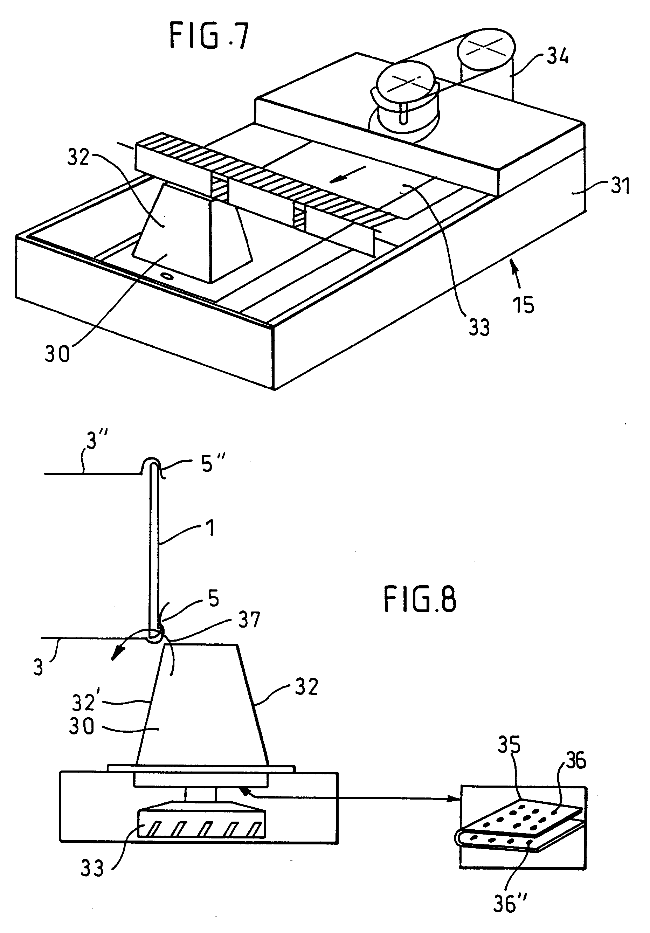

La figure 7 est une vue en perspective du poste de soudure (15). Il comprend essentiellement une cuve (31) en acier inoxydable équipée de résistances électriques maintenant l'étain qui sera utilisé pour la soudure à l'état de fusion à une température parfaitement définie. Cette cuve (31) est surmontée par une buse (30) dotée d'une face longitudinale avant (32) et d'une face longitudinale (32') au-dessus de laquelle circule le train de plaquettes. En (34) on a représenté une turbine. Cette turbine (34) est animée en rotation par un moteur doté d'un variateur électronique. Les aubes de cette turbine entraînent par impulsions successives le métal fondu dans un conduit (33) qui alimente la buse (30). Le niveau supérieur de métal fondu atteint dans la buse (30) est donc soumis à des variations préjudiciables à l'obtention d'une soudure régulière des plaquettes. Si l'on réduit la vitesse de rotation de la turbine, on réduit l'amplitude des impulsions mais cela se fait au détriment du débit de métal fondu et par suite de la hauteur du métal fondu au-dessus des bords de la buse. Cette difficulté a pu être surmontée par l'introduction dans l'alimentation de la partie supérieure de la buse d'une grille double (35) avec des ouvertures (36) et (36') décalées ainsi que le montre la figure 8 représentant une coupe verticale de la buse (30). Entre la buse (30) et l'extrémité supérieure du conduit (33), on interpose la grille (35).

Il en résulte que le flux de métal fondu est animé à la partie supérieure de la buse (30) d'un mouvement ajustable très légèrement ascendant et d'un mouvement longitudinal correspondant à l'écoulement du métal fondu vers les bords de la buse. Le mouvement ascendant du métal fondu dans la buse résulte des impulsions successives de la turbine (34). Les impulsions sont très fortement atténuées par l'interposition d'une ou de plusieurs grilles doubles telles que (35) dotées d'ouvertures décalées telles que (36) et (36'). Par ce moyen, l'inventeur est arrivé à réduire l'amplitude des oscillations verticales à une valeur inférieure à un millimètre. Par le réglage de la hauteur des plaquettes, il est donc possible de ne tremper dans ce métal fondu que la ligne des pinces (5) à souder sans jamais risquer d'altérer les circuits hybrides fixés sur les plaquettes.

Enfin, il y a lieu de noter que le métal fondu poussé par la turbine (33) déborde de la buse (30) se déverse dans la cuve (3) en formant à la partie supérieure des parois (32) et (32') un arc tel que (37). C'est dans cet arc (37) que l'on fait passer la ligne des pinces (5) tout en gardant les connexions (3) en dehors du bain pour éviter le dépôt de gouttelettes parasites. Ainsi que nous l'avons mentionné plus haut, le train de plaquettes peut être soumis à un jet d'air chaud à la sortie de la buse (30) si l'on constate cependant qu'il tend à s'établir dans les plaquettes des contacts indésirables.

Dans le cas où l'utilisateur de la présente machine doit faire face à une commande peu importante, il reprendra les trains de plaquettes à la sortie de la machine et les replacera sur celle-ci après les avoir retournées afin de souder les contacts de l'autre partie des plaquettes. Si au contraire, l'utilisateur doit faire face à une commande importante, il mettra en oeuvre un équipement en ligne de deux machines qui permet la soudure des deux côtés d'un ensemble DIL sans intervention manuelle entre les deux machines : à la sortie de la première, on installe un dispositif pourvu d'un automate qui commande la prise de la pièce, son retournement à 180° et sa mise en position dans la deuxième machine. Un seul opérateur peut ainsi s'occuper de la ligne de soudure.

La soudure de plaquettes équipées de connexions latérales d'un seul côté (SIL) requiert un autre dispositif d'entraînement par le convoyeur. Si l'on veut souder les connexions de plaquettes assemblées en train de plaquettes, on utilisera une roue à picots. Si au contraire on veut souder les connexions de plaquettes séparées, celles-ci seront entraînées en mouvement par le convoyeur sur lequel on a monté des roulettes équipées de bagues de caoutchouc pour ne pas risquer une déterioration des plaquettes. On choisira des bagues de caoutchouc résistant à des températures de l'ordre de 150°C. A la sortie de la machine, on ajoutera un poste de découpe programmée (37) susceptible de découper à la demande les trains de plaquettes en pièces individuelles séparées si cela s'avère souhaitable. Pour effectuer la soudure des connexions, il est nécessaire que les parois (32) du poste de soudage soient d'une hauteur supérieure à la longueur des connexions afin de permettre le mouillage de la partie inférieure de la plaquette. Le réglage de la turbine (34) sera donc plus énergique que celui qui est recherché pour la soudure de plaquettes (DIL).

Pour conclure, il y a lieu de faire deux remarques :
1/ Si l'intervalle entre deux connexions (3) successives est supérieur à deux millimètres, il est parfaitement possible de faire tremper les connexions (3) en même temps que la ligne des pinces (5) dans le métal fondu en faisant passer plus simplement le train de plaquettes entre deux parois latérales élevées sur les côtés de la buse.
2/ Si l'intervalle entre deux connexions (3) successives est de l'ordre du millimètre ou si il est inférieur à cette valeur, il n'est plus possible de tremper les connexions (3) dans le métal fondu en raison du risque de formation de gouttelettes parasites entre deux connexions successives.

Dans ce cas, seule la ligne des pinces (5) doit entrer en contact avec le métal fondu. Ce contact peut être très léger car, par capillarité, le métal fondu s'insinue entre les pinces (5) et les plages conductrices (2) de la plaquette (1). Ce contact entre la ligne des pinces (5) et le métal fondu se fait le long de l'arc (37) que le métal fondu forme en se déversant par dessus le bord de la paroi longitudinale arrière (32') de la buse (30). En raison de la miniaturisation des dispositifs électroniques. C'est ce deuxième procédé qui devient le plus facilement adaptable au soudage de plaquettes de très petites dimensions.

Enfin dans certaines plaquettes, toute la partie active des circuits électroniques est entièrement protégée par une couche de silicium. Seuls les jonctions des connexions sont nues.Dans ce cas, on peu tremper directement dans le flux de soudage la plaquette maintenue en position rigoureusement horizontale.

## Revendications

1. Machine permettant de souder en continu des connexions très rapprochées et régulièrement réparties sur des plaquettes (1) portant des circuits électroniques, constituée par un banc parcouru longitudinalement par un convoyeur (10), entraînant les plaquettes portant les connexions à souder fixées mécaniquement aux plages conductrices (2) vers les buses (30) du poste de soudage (15), caractérisée en ce que seules les plaquettes (1) sont maintenues durant tout leur trajet sur le banc dans une position verticale de telle sorte que seule la ligne de pinces (5) à souder sur les plages (2) de la plaquette (1) est mise en contact avec le métal fondu se déversant à l'extérieur de la buse (30) sous la poussée de la turbine (34).

2. Machine permettant selon la revendication 1 de souder des connexions aux bords latéraux des plaquettes, comportant un poste de fluxage, un poste de soudure (15), caractérisée en ce que les connexions (3) des plaquettes restent à l'extérieur de la buse (30) et ne sont absolument pas mouillées par le métal fondu.

3. Machine permettant selon les revendications 1 et 2 de souder en continu des connexions sur les plaquettes, caractérisée en ce que le niveau du métal fondu à la surface de la buse et la position de l'arc d'écoulement (37) du métal fondu par les parois (32) et (32') sont stabilisées par l'interposition l'une ou plusieurs grilles doubles (35) portant des ouvertures décalées (36) et (36') qui atténuent fortement les impulsions de la turbine d'alimentation (34).

4. Machine permettant selon la revendication 3 de souder en continu des connexions sur des plaquettes, caractérisée en ce que la position précise de ligne de soudures (5', 5'') au contact de l'arc d'écoulement (37) du métal fondu à l'extérieur de la buse est définie tant par le réglage précis de la vitesse de rotation de la turbine (34) que par un réglage manuel de la hauteur du convoyeur (10) par les chandelles (12') qui le supportent.

5. Machine permettant selon la revendication 1 de souder en continu des connexions sur des plaquettes, caractérisée en ce que la température de préchauffage de la zone de soudure de la plaquette est réglée à la sortie du tunnel (22) à une valeur inférieure de 60°C à la température du métal fondu dans la buse de soudure (30).

6. Installation permettant selon la revendication 1 de souder en continu des connexions successivement sur les deux bords latéraux des plaquettes (DIL), caractérisée en ce qu'elle est constituée de deux bancs de soudure reliés par un automate qui saisit la pièce à sa sortie du poste de soudure du premier banc, la retourne à 180° et la met en position sur le deuxième banc de soudure.

7. Machine selon les revendications 1, 3 et 4, utilisée à souder des plaquettes (SIL) qui ne sont dotées de connexions que sur l'un de leurs bords latéraux, caractérisée en ce que le moyen de préhension installé sur le convoyeur est constitué de roulettes équipées de bagues en caoutchouc.

8. Machine selon la revendication 7 destinée à souder les plaquettes (SIL), caractérisée en ce qu'à la sortie de la machine à souder, on dispose un poste de découpe programmée (37) susceptible de découper à la demande les trains de plaquettes en pièces individuelles.
